# EUROPÄISCHE PATENTANMELDUNG

(11) **EP 4 697 923 A1**
(43) Veröffentlichungstag der Anmeldung: **18.02.2026**
(21) Anmeldenummer: 25190837.2
(22) Anmeldetag: 21.07.2025
(51) Int. Cl.: H10W 40/47, H10W 76/60, H10W 40/60, H10W 40/22, H10W 40/25

(54) **LEISTUNGSMODUL FÜR EINEN PULSWECHSELRICHTER**

(30) Priorität: 30.07.2024 DE 102024207167
(71) Anmelder: VOLKSWAGEN AG, 38440 Wolfsburg (DE)
(72) Erfinder: Michelsen, Steffen, 38440 Wolfsburg (DE); Unrau, Arthur, 38440 Wolfsburg (DE); Uhlig, Dr. Johannes, 38440 Wolfsburg (DE); Herold, Alexander, 38440 Wolfsburg (DE)

(57) **Zusammenfassung**

Die Erfindung betrifft eine Leistungselektronik für einen Pulswechselrichter, mit zumindest einem Leistungsmodul (1), das zumindest ein Halbleiterelement (3) und ein Substrat (9) aufweist, auf dem das Halbleiterelement (3) gelötet oder gesintert ist, und mit einem Kühler (2) zur Entwärmung des Leistungsmoduls (1), wobei der Kühler (2) einen kühlmitteldurchströmten Freiraum (15) aufweist, der zwischen der Substrat-Unterseite (14) und einem damit kraftschlüssig verspannten, insbesondere schalenförmigen Kühlerelement (17) definiert ist. Erfindungsgemäß weist die kraftschlüssige Verbindung zwischen der Substrat-Unterseite (14) und dem Kühlerelement (17) zumindest eine Niet- oder Schraubverbindung (N; S) auf, bei der die Substrat-Unterseite (14) mittels eines Niet- oder Schraubbolzens (35; 43), insbesondere ohne weitere Hilfsfügelemente, etwa einem Klemm- oder Spannrahmen (29), direkt an das Kühlerelement (17) angebunden ist.

## Beschreibung

Die Erfindung betrifft eine Leistungselektronik für einen Pulswechselrichter nach dem Oberbegriff des Anspruches 1.

Die Leistungselektronik für einen Pulswechselrichter muss eine angemessene Wärmeableitung der Halbleiterelemente des Leistungsmoduls gewährleisten. Hierzu sind die Halbleiterelemente des Leistungsmoduls in thermischer Verbindung mit einem zum Beispiel kühlmitteldurchströmten Kühler.

In einer gattungsgemäßen Leistungselektronik weist der Kühler einen kühlmitteldurchströmten Freiraum auf, der zwischen einer Substrat-Unterseite des Leistungsmoduls und einem Kühlerelement definiert ist. Im Stand der Technik ist die Substrat-Unterseite über eine rahmenförmige Spanneinheit mit dem schalenförmigen Kühlerelement verspannt. Die rahmenförmige Spanneinheit kann einen Spannrahmen mit Winkelprofil aufweisen, bei dem ein Klemmschenkel das Substrat gegen das Kühlerelement drückt, und ein dazu rechtwinkliger Montageschenkel über eine Schraubverbindung mit dem Kühlerelement verschraubt ist. In diesem Fall ist das Substrat beziehungsweise dessen Substrat-Unterseite zwischen dem Klemmschenkel des Spannrahmens und dem Kühlerelement zwischengeklemmt.

Eine solche Klemmverbindung über einen Klemm- oder Spannrahmen ist verhältnismäßig bauteilintensiv sowie bauraumintensiv. Außerdem kann es aufgrund unterschiedlicher Wärmeausdehnungskoeffizienten der beteiligten Komponenten zu einem thermomechanischen Stress in der Bauteilanordnung kommen.

Aus der DE 10 2019 114 001 A1 ist eine Leistungselektronikeinheit für einen Elektromotor eines Kraftfahrzeugantriebs bekannt, mit einem plattenförmigen Kühlkörper, zumindest einem Halbleitermodul sowie einem aus einem Kunststoff bestehenden, das zumindest eine Halbleitermodul relativ zu dem Kühlkörper festlegenden Modulhalter, wobei der Modulhalter über eine formschlüssige Schnappverbindung an dem Kühlkörper fixiert ist. Aus der DE 10 2020 207 947 A1 ist eine Kühlanordnung für elektronische Komponenten eines Kraftfahrzeugs bekannt. Diese zeichnet sich dadurch aus, dass ein Sockelkasten als eine aus einem Blech umgeformte Wanne mit einem fluiddicht stoffschlüssig eingesetzten Längssteg ausgebildet ist, mittels dessen die Wanne in die Einlass-Längskammer und die Auslass-Längskammer unterteilt ist.

Die Aufgabe der Erfindung besteht darin, eine Leistungselektronik für einen Pulswechselrichter bereitzustellen, bei der die Anbindung zwischen Substrat-Unterseite und Kühlerelement im Vergleich zum Stand der Technik konstruktiv einfacher durchgeführt ist.

Die Aufgabe ist durch die Merkmale des Anspruches 1 gelöst. Bevorzugte Weiterbildungen der Erfindung sind in den Unteransprüchen offenbart.

Die Erfindung betrifft eine Leistungselektronik für einen Pulswechselrichter. Diese ist aus zumindest einem Leistungsmodul, das zumindest ein Halbleiterelement und ein Substrat aufweist, auf dem das Halbleiterelement gelötet oder gesintert ist, und einem Kühler zur Entwärmung des Leistungsmoduls aufgebaut. Der Kühler weist einen kühlmitteldurchströmten Freiraum auf, der zwischen der Substrat-Unterseite und einem damit kraftschlüssig verspannten, insbesondere schalenförmigen Kühlerelement definiert ist. Gemäß dem kennzeichnenden Teil des Anspruches 1 sind folgende Maßnahmen getroffen, um eine konstruktiv einfache sowie mit geringem thermomechanischen Stress behaftete Anbindung des Leistungsmoduls am Kühler zu bewerkstelligen: So ist weist die kraftschlüssige Verbindung zwischen der Substrat-Unterseite und dem Kühlerelement zumindest eine Niet- oder Schraubverbindung auf, bei der die Substrat-Unterseite mittels eines Niet- oder Schraubbolzens, insbesondere ohne weitere Hilfsfügelemente, etwa einem Klemm- oder Spannrahmen, direkt an das Kühlerelement angebunden ist. Mittels der Erfindung kann die Anbindung mit reduziertem Bauteilaufwand realisiert werden. Außerdem wird mittels der erfindungsgemäßen direkten Niet- oder Schraubverbindung eine ausreichende Relativbewegung zwischen den Fügepartnern aufgrund unterschiedlicher Wärmeausdehnungskoeffizienten ermöglicht. Eine solche Relativbewegung würde etwa bei einer großflächigen stoffschlüssigen Anbindung nicht möglich sein.

Bei der Erfindung handelt es sich also um ein integriertes Substrat, welches mittels zumindest einer direkten Schraubverbindungen auf einer Kunststoff-Kühlkörper-Schale montiert wird. Dabei wird bevorzugt durch schon im Herstellungsprozess des Kühlerelements eingebrachte Gewindeeinsätze in das Kühlerelement, eine kraftschlüssige Verbindung zwischen integriertem Substrat und dem Kühlerelement erzeugt, die dem Druck des Kühlkreislaufes standhält. Die Dichtfunktion wird in diesem Aufbau durch Dichtelemente zwischen dem Kühlerelement und dem Modulsubstrat realisiert. Die Dichtelemente können als separate O-Ringe oder als an den Kühler im 2k-Spritzguss angespritzte Gummilippen ausgeführt sein. Der zu erwartende mechanische Stress wird durch Einsätze in den Schraubenlöchern bzw. Montagelöchern des integrierten Substrates aufgenommen.

Ein wesentlicher Vorteil der Erfindung besteht darin, dass auf einen Spann- oder Klemmrahmen oder auf sonstige Niederhalte-Klammern verzichtet werden kann. Das integrierte Modul wird erfindungsgemäß direkt auf das offene schalenfömige Kühlerelement geschraubt. Die dafür benötigten Gewinde in der Kühlkörper-Schale werden bereits im Herstellungsprozess des Kühler-Schale eingebracht. Schraublöcher im Substrat werden in der Herstellung des integrierten Substrates bereits vorgesehen und anschließend mittels metallischer Einsätze zur Aufnahme von mechanischem Stress verstärkt.

In einer technischen Umsetzung kann das Substrat einen Dreilagenaufbau aus einer mittleren Keramiklage und aus beidseitig auf der Keramiklage beschichteten Substrat-Metalllagen aufweisen. Auf einer oberen Substrat-Metalllage kann das das Leistungsmodul gelötet oder gesintert sein, während auf eine untere Substrat-Metalllage die Substrat-Unterseite bildet, gegen die das Kühlerelement verspannt ist.

Im Hinblick auf eine fertigungstechnisch einfachen Fügevorgang ist es bevorzugt, wenn die untere Substrat-Metalllage mit einem freien Lagen-Überstand die mittlere Keramiklage und die obere Substrat-Metalllage seitlich überragt. In diesem Fall kann die Niet- oder Schraubverbindung einfach zugänglich zwischen dem freien Lagen-Überstand und dem Kühlerelement realisiert sein.

Die Substrat-Unterseite gegen eine seitlich hochgezogene Schalenwand des schalenförmigen Kühlerelements verspannt ist, so dass ein nach außen komplett geschlossener Kühler ausgebildet ist, bei dem das schalenförmige Kühlerelement von dem, den Deckel bildenden Leistungsmodul überdeckt ist. Das Leistungsmodul mit seinen Komponenten (d.h. Halbleiterelemente sowie Substrat) kann in einem ersten Zusammenbauschritt als eine einstückige Vormontageeinheit vorgefertigt werden. In einem nachfolgenden Fügeschritt kann die Vormontageeinheit auf das schalenförmige Kühlerelement gefügt werden.

In einer konkreten Ausführungsform ist der Schraub- oder Nietbolzen durch ein Montageloch der unteren Substrat-Metalllage geführt und in Niet- oder Gewindeeingriff mit dem Kühlerelement gebracht. Der Niet- oder Schraubbolzen kann bevorzugt seitlich um einen Querversatz versetzt zur Schalenwand des Kühlerelements in Niet- oder Gewindeeingriff mit dem Schalenboden des Kühlerelements sein. In diesem Fall bildet nicht die seitlich umlaufende Schalenwand, sondern der Schalenboden des schalenförmigen Kühlerelements eine Tragstruktur, in der der Gewinde- oder Nieteingriff erfolgt. Bei der Schraubverbindung ist die untere Substrat-Metalllage zwischen einem auf dem Öffnungsrandbereich des Montagelochs der unteren Substrat-Metalllage abgestützten Bolzenkopf und dem Kühlerelement verspannt.

Zur Reduzierung von auf die untere Substrat-Metalllage wirkenden Kraftspitzen kann im Material der unteren Substrat-Metalllage eine Metallhülse eingebettet sein, die das Montageloch begrenzt. In gleicher Weise kann zur Reduzierung von auf das Kühlerelement wirkenden Kraftspitzen im Kühlerelement-Material ein Metalleinsatz, d.h. eine Gewindehülse, mit Innengewinde eingebettet sein, in das der Schraubbolzen einschraubbar ist. Im obigen Ausführungsbeispiel wird das integrierte Substrat auf dem schalenfömigen Kühlerelement mit eingebrachten Gewindehülsen montiert. Verstärkende Einsätze in den Schraubenlöcher bzw. Montagelöchern des integrierten Substrates werden bereits in der Fertigung des integrierten Substrates beim Hersteller eingebracht.

Die Verschraubung in eingefügte Gewindeeinsätze in dem schalenförmigen Kühlerelement bietet den Vorteil, dass bei einem Modul-Ausfall dieses ohne Austausch des schalenförmigen Kühlerelements (d.h. Kühler-Halbschale) und der damit verbundenen weiteren Bauteile ersetzt werden kann. Das Einbringen der verstärkenden Einsätze direkt im Herstellungsprozess der integrierten Substrate bietet darüber hinaus den Vorteil, dass ein Handling der Einsätze in der Montage der Leistungsboxen nicht benötigt wird.

Alternativ zur obigen Ausführungsvariante kann der Schraubbolzen ein selbstfurchendes Gewinde aufweisen. In diesem Fall wird der Schraubbolzen während des Fügevorgangs in Gewindeeingriff mit dem Kühlerelement gebracht, und zwar ohne vorgefertigte Innengewindebohrung im Kühlerelement. Durch selbstschneidende Schrauben können hier die Kosten der Gewindeeinsätze eingespart werden.

Bevorzugt ist es, wenn die Niet- oder Schraubverbindung nicht im Nassbereich, d.h. im kühlmitteldurchströmten Freiraum positioniert ist, sondern vielmehr in einem Trockenbereich. Vor diesem Hintergrund kann der Freiraum zwischen der Substrat-Unterseite und dem Kühlerelement mittels eines Dichtelements in einen kühlmitteldurchströmten Bereich und einem trockenen Montageraum unterteilt sein. Das Dichtelement kann - unter Bildung eines trockenen Montageraums - über einen Querversatz von der Schalenwand des schalenförmigen Kühlerelements beabstandet sein. Durch den trockenen Montageraum kann bevorzugt der Niet- oder Schraubbolzen geführt sein.

Die Nietverbindung kann bevorzugt wie folgt realisiert sein: So kann der Nietbolzen durch ein im Kühlerelement ausgebildetes Montageloch nach außen geführt sein. In der Nietverbindung kann die untere Substrat-Metalllage und das Kühlerelement zwischen einem am Öffnungsrandbereich des Montageloches der Substrat-Metalllage abgestützten ersten Bolzenkopf und einem am Öffnungsrandbereich des Montagelochs des Kühlerelements abgestützten zweiten Bolzenkopf des Nietbolzens verspannt sein.

Nachfolgend sind Ausführungsbeispiele der Erfindung sowie nicht von der Erfindung umfasste Vergleichsbeispiele anhand der beigefügten Figuren beschrieben. Es zeigen:
- Figuren 1 bis 3: jeweils Ansichten einer Leistungselektronik gemäß unterschiedlicher Ausführungsbeispiele; und
- Figur 4 und 5: in einer Ansicht entsprechend der Figuren 1 bis 3 jeweils ein nicht von der Erfindung umfasstes Vergleichsbeispiel.

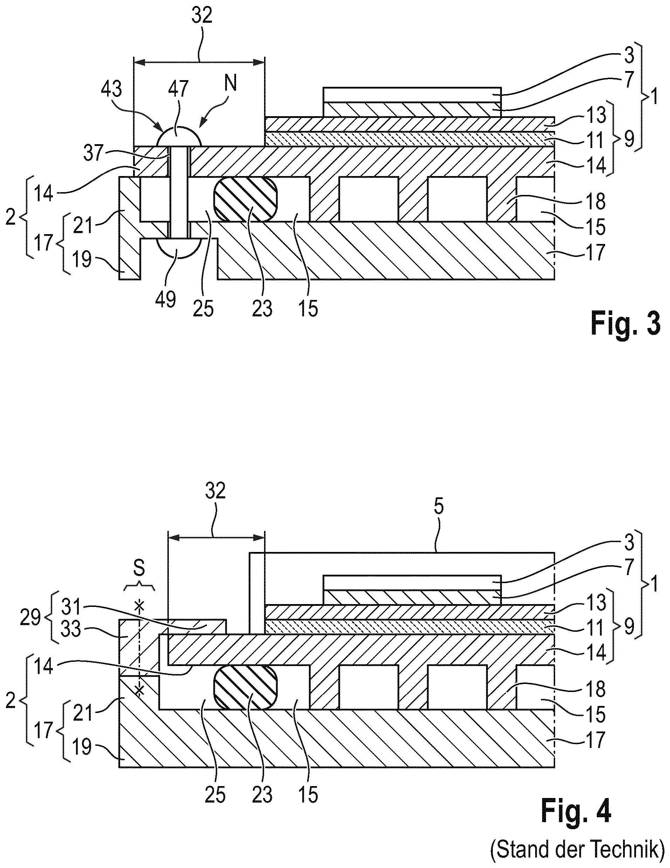

Im Hinblick auf ein einfacheres Verständnis der Erfindung wird zunächst Bezug auf das in der Figur 4 gezeigte, nicht von der Erfindung umfasste Vergleichsbeispiel genommen. In der Figur 4 ist ein Leistungsmodul 1 einer Leistungselektronik für einen Pulswechselrichter angedeutet. Die Leistungselektronik bildet neben weiteren Baugruppen, etwa Steuerplatine, Zwischenkreiskondensator sowie EMV-Einheit einen Bestandteil des Pulswechselrichters. In einer tatsächlichen (jedoch nicht gezeigten) Anwendung ist die Leistungselektronik beispielhaft für drei Phasen mit entsprechend drei Leistungsmodulen 1 sowie einem Kühler 2 aufgebaut. Jedes dieser drei Leistungsmodule 1 weist beispielhaft eine Halbbrücke bestehend aus zwei Halbleiterbauelementen 3 auf, von denen in der Figur 4 lediglich ein Halbleiterbauelement 3 gezeigt ist. Das Halbleiterbauelement 3 ist in einer Vergussmasse 5 eingegossen, die in der Figur 4 lediglich mit einer Umrisslinie angedeutet ist. In den Figuren sind weitere Komponenten des Pulswechselrichters aus Gründen der Übersichtlichkeit weggelassen. Außerdem ist das Halbleiterelement 3 über eine Sinterschicht7 auf ein Substrat 9 appliziert. Das Substrat 9 weist in der Figur 4 einen Dreilagenaufbau auf, bestehend aus einer oberen Aluminiumlage 13, einer mittleren Keramiklage 11 und einer unteren Aluminiumlage 14, die die Substrat-Unterseite bildet.

Wie aus der Figur 4 weiter hervorgeht, weist der Kühler 2 einen kühlmitteldurchströmten Freiraum 15 auf, der zwischen der Substrat-Unterseite (das heißt der unteren Aluminiumlage 14) und einem damit kraftschlüssig verspannten, schalenförmigen Kühlerelement 17 definiert ist. Auf der von dem Halbleiterelement 3 abgewandten Seite der unteren Aluminiumlage 14 sind Kühlerrippen 18 angeformt, die sich auf einem Schalenboden 19 des schalenförmigen Kühlerelements 17 abstützen. Zudem ist von einer seitlichen Schalenwand 21 des Kühlerelements 17 um einen Querversatz nach innen versetzt ein Dichtelement 23 angeordnet. Das Dichtelement 23 ist zwischen der Substrat-Unterseite (das heißt die untere Aluminiumlage 14) und dem Schalenboden 19 des Kühlerelements 17 verpresst und trennt den kühlmitteldurchströmten Freiraum 15 von einem äußeren trockenen Montageraum 25 ab.

In der Figur 4 ist die Substrat-Unterseite (das heißt die untere Aluminiumlage 14) über eine rahmenförmige Spanneinheit mit dem schalenförmigen Kühlerelement 14 verspannt. Die rahmenförmige Spanneinheit weist in der Figur 4 einen Klemmrahmen 29 auf, der im Querschnitt als Winkelprofil gebildet ist, bei dem ein horizontaler Klemmschenkel 31 einen Lagen-Überstand 32 der unteren Aluminiumlage 14 unter Zwischenlage des Dichtelements 23 gegen den Schalenboden 19 des Kühlerelements 17 drückt, und ein dazu rechtwinkliger, vertikaler Montageschenkel 33 über eine Schraubverbindung S mit dem Kühlerelement 17 verschraubt ist. Entsprechend ist die untere Aluminiumlage 14 des Substrats 9 des Leistungsmoduls 1 zwischen dem Klemmrahmen 29 und dem Kühlerelement 17 geklemmt.

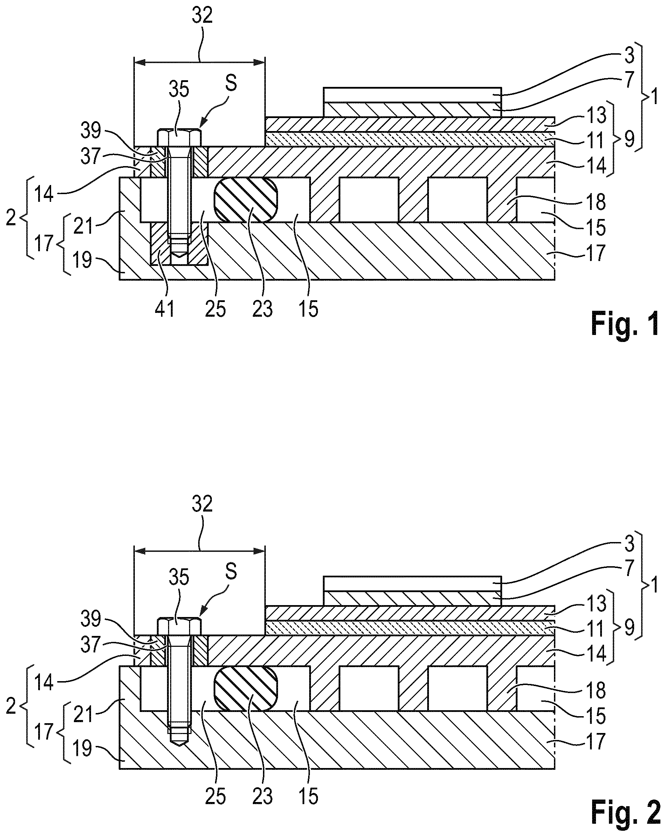

In Abkehr davon ist in der Figur 1 ein erstes Ausführungsbeispiel der Erfindung gezeigt. Dessen Aufbau und Funktionsweise entspricht im Wesentlichen dem Aufbau und der Funktionswese des in der Figur 4 gezeigten Vergleichsbeispiels. Von daher wird auf die Vorbeschreibung verwiesen. Im Unterschied zur Figur 4 ist in der Figur 1 auf die Bereitstellung des Klemmrahmens 29 verzichtet. Anstelle dessen ist in der Figur 1 die untere Aluminiumlage 14 des Substrats 9 an ihrem jeweiligen Lagen-Überstand 33 in direkter Schraubverbindung S mit dem Schalenboden 19 des Kühlerelements 17. Die Schraubverbindung S weist einen Schraubbolzen 35 auf, der durch ein Montageloch 37 im Lagen-Überstand 32 der unteren Aluminiumlage 14 sowie durch den trockenen Montageraum 25 des Kühlers 2 bis in Gewindeeingriff mit dem Schalenboden 19 des Kühlerelements 17 geführt ist. In der Figur 1 ist die untere Aluminiumlage 14 randseitig auf einer Oberkante der umlaufenden Schalenwand 21 des Kühlerelements 17 abgestützt.

Zur Reduzierung von auf die untere Aluminiumlage 14 wirkenden Kraftspitzen ist im Material der unteren Aluminiumlage 14 eine Metallhülse 39 eingebettet, die das Montageloch 37 begrenzt. Zur weiteren Reduzierung von auf das schalenförmige Kühlerelement 17 wirkenden Kraftspitzen ist im Kühlerelement-Material ein Metalleinsatz 41 mit Innengewinde eingebettet, in das der Schraubbolzen 35 einschraubbar ist.

In der Figur 2 ist ein zweites Ausführungsbeispiel der Erfindung gezeigt, und zwar in einer Ansicht entsprechend der Figur 1. Der Aufbau sowie die Funktionsweise des in der Figur 2 gezeigten Ausführungsbeispiels entspricht im Wesentlichen dem Aufbau sowie der Funktionsweise des in der Figur 1 gezeigten Ausführungsbeispiels, so dass auf die Vorbeschreibung verwiesen wird. Im Unterschied zur Figur 1 ist in der Figur 2 der Schraubbolzen 35 mit einem selbstfurchenden Außengewinde versehen. Während des Fügevorgangs wird daher der Schraubbolzen 35 in das Material des Schalenbodens 19 des Kühlerelements 17 eingetrieben, und zwar ohne vorgefertigte Innengewindebohrung im Schalenboden 19.

In der Figur 3 ist ein weiteres Ausführungsbeispiel in einer Ansicht entsprechend der vorangegangenen Figuren gezeigt. Im Unterschied zu den vorangegangenen Figuren ist in der Figur 3 die kraftschlüssige Verbindung zwischen dem Leistungsmodul 1 und dem schalenförmigen Kühlerelement 17 als Nietverbindung N ausgeführt. In der Nietverbindung N ist ein Nietbolzen 43 durch das Montageloch 37 der unteren Aluminiumlage 14 geführt. Der Nietbolzen 43 durchsetzt den trockenen Montageraum 25 des Kühlers 2 und ist durch ein im Schalenboden 19 ausgebildetes Montageloch 45 nach außen geführt. In der dargestellten Nietverbindung N ist die untere Aluminiumlage 14 des Substrats 9 und das schalenförmige Kühlerelement 19 zwischen einem am Öffnungsrandbereich des Montageloches 37 der unteren Aluminiumlage 14 abgestützten ersten Bolzenkopf 47 und einem am Öffnungsrandbereich des Montageloches 45 im Kühlerelement 17 abgestützten zweiten Bolzenkopf 49 des Nietbolzens 43 verspannt.

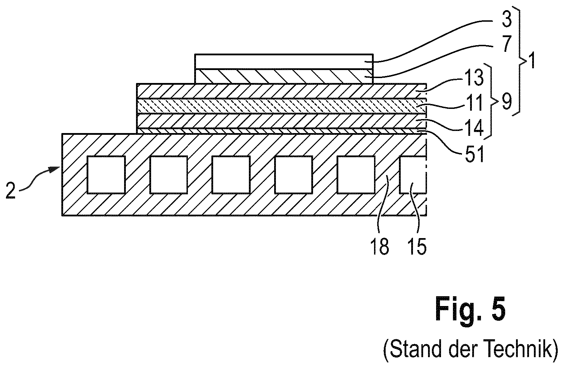

In der Figur 5 ist ein weiteres Vergleichsbeispiel in einer Ansicht entsprechend der vorangegangenen Figuren gezeigt. Im Unterschied zu den vorangegangenen Figuren ist in der Figur 5 die Substrat-Unterseite, das heißt die untere Aluminiumlage 14 des Substrats 9, nicht kraftschlüssig mit dem Kühler 2 verspannt, sondern vielmehr über eine Verbindungsschicht, d.h. Löt- oder Sinterschicht 51, mit einem geschlossenen Kühler 2 stoffschlüssig verbunden. Im Gegensatz zur Erfindung ist daher die Substrat-Unterseite 14 großflächig in stoffschlüssiger Verbindung mit dem Kühler 2. Bei Verwendung eines solchen geschlossenen Kühlers 2 muss die Verbindungsschicht 51 nicht nur die thermische, sondern auch die mechanische Anbindung übernehmen. Im Vergleich zur Erfindung baut sich daher ein wesentlich größerer thermomechanischer Stress in der Verbindungsschicht 51 auf, und zwar aufgrund von Unterschieden in den Wärmeausdehnungskoeffizienten des Kühlers 2 und der Keramiklage 11 . Dies kann zu einer Erhöhung des thermischen Widerstands sowie zu einer Delamination des Leistungsmoduls 1 vom Kühler 2 führen. Im Gegensatz dazu verbleibt bei der erfindungsgemäßen direkten Schraubverbindung S zwischen dem Leistungsmodul 1 und dem Kühler 2 ausreichend Spielraum für Verformungen, um die unterschiedlichen Wärmeausdehnungen zwischen der unteren Aluminiumlage 14 und dem üblicherweise aus Kunststoff gefertigten schalenförmigen Kühlerelement 19 zu gewährleisten.

### Bezugszeichenliste

- 1: Leistungsmodul
- 2: Kühler
- 3: Halbleiterbauelement
- 5: Vergussmasse
- 7: Sinterschicht
- 9: Substrat
- 11: mittlere Keramiklage
- 13: obere Aluminiumlage
- 14: untere Aluminiumlage
- 15: Freiraum
- 17: Kühlerelement
- 18: Kühlerrippen
- 19: Schalenboden
- 21: Schalenwand
- 23: Dichtelement
- 25: trockener Montageraum
- 29: Klemmrahmen
- 32: Lagen-Überstand
- 35: Schraubbolzen
- 37: Montageloch
- 39: Metallhülse
- 41: Metalleinsatz mit Innengewinde
- 43: Nietbolzen
- 45: Montageloch
- 47: erster Bolzenkopf
- 49: zweiter Bolzenkopf
- 51: Verbindungsschicht
- N: Nietverbindung
- S: Schraubverbindung

## Patentansprüche

1. Leistungselektronik für einen Pulswechselrichter, mit zumindest einem Leistungsmodul (1), das zumindest ein Halbleiterelement (3) und ein Substrat (9) aufweist, auf dem das Halbleiterelement (3) gelötet oder gesintert ist, und mit einem Kühler (2) zur Entwärmung des Leistungsmoduls (1), wobei der Kühler (2) einen kühlmitteldurchströmten Freiraum (15) aufweist, der zwischen der Substrat-Unterseite (14) und einem damit kraftschlüssig verspannten, insbesondere schalenförmigen Kühlerelement (17) definiert ist, **dadurch gekennzeichnet, dass** die kraftschlüssige Verbindung zwischen der Substrat-Unterseite (14) und dem Kühlerelement (17) zumindest eine Niet- oder Schraubverbindung (N; S) aufweist, bei der die Substrat-Unterseite (14) mittels eines Niet- oder Schraubbolzens (35; 43), insbesondere ohne weitere Hilfsfügelemente, etwa einem Klemm- oder Spannrahmen (29), direkt an das Kühlerelement (17) angebunden ist.

2. Leistungselektronik nach Anspruch 1, **dadurch gekennzeichnet, dass** das Substrat (9) einen Dreilagenaufbau aus einer mittleren Keramiklage (11) und aus beidseitig auf der Keramiklage (11) beschichteten Substrat-Metalllagen (13, 14) aufweist, und dass insbesondere auf einer oberen Substrat-Metalllage (13) das Leistungsmodul (1) gelötet oder gesintert ist, und/oder dass eine untere Substrat-Metalllage (14) die Substrat-Unterseite bildet.

3. Leistungselektronik nach Anspruch 2, **dadurch gekennzeichnet, dass** die untere Substrat-Metalllage (14) mit einem freien Lagen-Überstand (32) die Keramiklage (11) und die obere Substrat-Metalllage (13) seitlich überragt, und dass die Niet- oder Schraubverbindung (N, S) zwischen dem freien Lagen-Überstand (32) und dem Kühlerelement (17) realisiert ist.

4. Leistungselektronik nach Anspruch 1, 2 oder 3, **dadurch gekennzeichnet, dass** die Substrat-Unterseite (14) gegen eine seitlich hochgezogene Schalenwand (21) des schalenförmigen Kühlerelements (17) verspannt ist.

5. Leistungselektronik nach einem der vorhergehenden Ansprüche, **dadurch gekennzeichnet, dass** der Schraub- oder Nietbolzen (35; 43) durch ein Montageloch (37) der unteren Substrat-Metalllage (14) geführt ist und in Niet- oder Gewindeeingriff mit dem Kühlerelement (17) ist, und zwar insbesondere seitlich um einen Querversatz versetzt zur Schalenwand (21) des Kühlerelements (17) in Niet- oder Gewindeeingriff mit dem Schalenboden (19) des Kühlerelements (17) ist, und/oder dass bei der Schraubverbindung (S) die untere Substrat-Metalllage (14) zwischen einem auf dem Öffnungsrandbereich des Montagelochs (37) der unteren Substrat-Metalllage (14) abgestützten Bolzenkopf und dem Kühlerelement (17) verspannt ist.

6. Leistungselektronik nach einem der Ansprüche 2 bis 5, **dadurch gekennzeichnet, dass** zur Reduzierung von auf die untere Substrat-Metalllage (14) wirkenden Kraftspitzen im Material der unteren Substrat-Metalllage (14) eine Metallhülse (39) eingebettet ist, die das Montageloch (37) begrenzt.

7. Leistungselektronik nach einem der vorhergehenden Ansprüche, **dadurch gekennzeichnet, dass** zur Reduzierung von auf das Kühlerelement (17) wirkenden Kraftspitzen im Kühlerelement-Material ein Metalleinsatz (41) mit Innengewinde eingebettet ist, in das der Schraubbolzen (35) einschraubbar ist.

8. Leistungselektronik nach einem der vorhergehenden Ansprüche, **dadurch gekennzeichnet, dass** der Schraubbolzen (35) ein selbstfurchendes Gewinde aufweist, das während des Fügevorgangs in Gewindeeingriff mit dem Kühlerelement (17) bringbar ist, und zwar ohne vorgefertigte Innengewindebohrung im Kühlerelement (17).

9. Leistungselektronik nach einem der Ansprüche, **dadurch gekennzeichnet, dass** der kühlmitteldurchströmte Freiraum (15) zwischen der Substrat-Unterseite (14) und dem Kühlerelement (17) mittels zumindest eines Dichtelements (23) begrenzt ist, das zwischen der Substrat-Unterseite (14) und dem Kühlerelement (17) verpresst ist, und dass insbesondere das Dichtelement (23) über einen Querversatz von der Schalenwand (21) des schalenförmigen Kühlerelements (17) beabstandet ist, und zwar unter Bildung eines trockenen Montageraums (25), durch den der Niet- oder Schraubbolzen (35; 43) geführt ist.

10. Leistungselektronik nach einem der vorhergehenden Ansprüche, **dadurch gekennzeichnet, dass** in der Nietverbindung (N) der Nietbolzen (43) durch ein im Kühlerelement (17) ausgebildetes Montageloch (45) nach außen geführt ist, und dass in der Nietverbindung (N) die untere Substrat- Substrat-Metalllage (14) und das Kühlerelement (17) zwischen einem am Öffnungsrandbereich der Substrat-Metalllage (14) abgestützten ersten Bolzenkopf (47) und einem am Öffnungsrandbereich des Kühlerelements (17) abgestützten zweiten Bolzenkopf (49) des Nietbolzens (43) verspannt ist.
